# EUROPEAN PATENT APPLICATION

(11) **EP 2 113 935 A2**
(43) Date of publication of application: **04.11.2009**
(21) Application number: 09005376.0
(22) Date of filing: 15.04.2009
(51) Int. Cl.: H01L 21/00, H01L 21/677

(54) **Soaking device with single surface etching capability**

(30) Priority: 01.05.2008 TW 97207549 U
(71) Applicant: Wakom Semiconductor Corporation, Hsinchu County 30352 (TW)
(72) Inventor: Chen, Chung-I, Hsinchu County 30352 (TW)
(74) Representative: Strehl Schübel-Hopf & Partner

(57) **Abstract**

The present invention relates to a soaking device with single surface etching, installed in an etching tank of wet bench process, the device includes a soaking case, which is a case member with an open top end and has an accommodating space; and a convey mechanism, composed by a plurality of rolling columns being in parallel and pivotally provided on two opposite walls of the soaking case, so the rolling columns are received in the accommodating space, wherein the surface of each of the rolling columns is provided with a plurality of elongated concave sections separated with a same interval; when chemical solution is filled in the accommodating space, the liquid level of chemical solution is not higher than the top ends of the rolling columns; when the rolling columns are rotated, an electronic component placed on top of the rolling columns is conveyed, and when the plural elongated concave sections of each of the rolling columns leave the surface of the chemical solution, the concave sections can suck and carry the chemical solution; so when each of the concave sections is rotated to the bottom surface of the electronic component, the chemical solution can be delivered to the bottom surface of the electronic component through liquid adhesion forces, and a single surface etching is therefore processed.

## Description

### BACKGROUND OF THE INVENTION

### Field of the Invention:

The present invention relates to a soaking device, more particularly to a soaking device with single surface etching capability, said device is installed in an etching tank of wet bench process equipments, rolling columns thereof have functions of sucking and carrying chemical solution for processing single surface etching on an electronic component, e.g. a wafer.

### Description of Related Art:

The wet chemical etching process is commonly used in semiconductor production, especially used in discrete components or large-scale integrated circuits, e.g. a wafer or a solar cell wafer. In semiconductor industry, the wet processes have many applications for production processes, e.g. removing photoresist, removing silicon nitride or silicate glass. In General, wet bench equipments for wet chemical etch perform plural process steps such as main wet etch process, intermediary wash, rinse and drying steps.

To process the main etch process on an electronic component e.g. a wafer, two methods are commonly adopted, wherein one is to utilize a carrier e.g. a cassette rack, at least one pair of retaining rods thereof are provided with plural wafers, then a rail-type transport mechanism is served to hoist the cassette rack for being moved and soaked in chemical solution in an etching tank, so a double surface etching reaction is processed. The other method is to place a soaking device with a wafer roller conveyer mechanism into an etching tank, and wafers are conveyed by rollers, through rotations of plural rolling columns provided on a convey device, so a double surface etching reaction is processed.

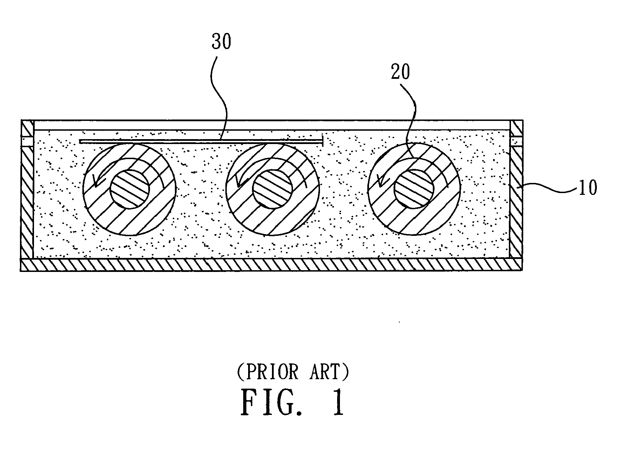

As shown in FIG. 1, which is a cross sectional view of a conventional soaking device, which is a soaking case 10 with an open top end, the soaking case 10 is provided in a wet etching bench (not shown), and the interior thereof is provided with a plurality of rolling columns 20 arranged in parallel, chemical solution is circulated by a pump to deliver to the soaking case 10 for an etching reaction. The rolling columns 20 are rotated in a direction marked with an arrow (counterclockwise direction), so an electronic component 30 e.g. a wafer soaked in the chemical solution can be conveyed. Because the whole wafer 30 is soaked and submerged in the chemical solution, a double surface etching is processed on the wafer 30 in the soaking device.

For some applications on wafers, for example a solar cell wafer whose reaction surface has already been fabricated with circuits or a deposition layer, and a surface treatment is only desired for the non-reaction, opposite surface, or in a situation where only one surface of a wafer is to be etched, the above mentioned double surface etching cassette rack or soaking device are not able to satisfy such needs for single surface etching function. A conventional means for overcoming this drawback is that a non-etching surface of an electronic component e.g. a wafer is covered by a protection layer or film, then the whole electronic component is provided in the cassette rack, or is soaked in the soaking device for processing a single surface etching function. Such means are not only time consuming but also lower production efficiency. So for a wet bench process equipment, the method how to control liquid level of chemical solution in a soaking device so that rolling columns are able to process a single surface etching on the bottom surface of an electronic component shall be well conceived.

### SUMMARY OF THE INVENTION

The applicant of the present invention has been devoted himself to design and commercially market electronic components equipments especially wafer process equipments, with a hope to overcome drawbacks that conventional wet process equipments can only provide a double surface etching function, and a single surface etching function has be to carried out by covering the surface that is not intended to be etched. The applicant improves the structure of conventional soaking device in wet process equipments for performing a single surface etching function, after trial and error, comes up with the present invention "Soaking device with single surface etching capability".

The main object of the present invention is to modify rolling columns of a convey mechanism used in a soaking device, so that when the rolling columns are rotated, chemical solution is synchronously sucked and carried for processing a single surface etching function on the bottom surface of an electronic component. Because the present invention provides a single surface etching capability, the material loss of the electronic component is reduced and service life of chemical solution is prolonged. Moreover, gas generated during the etching reaction is to be discharged more easily through gaps between the rolling columns so an operator is less likely to be harmed by the gas.

For achieving the described object, one solution provided by the present invention is to provide a soaking device with single surface etching capability, installed in an etching tank of wet bench process equipments, the device includes a soaking case, which is a case member with an open top end and has an accommodating space; and a convey mechanism composed by a plurality of rolling columns being in parallel and pivotally provided on two opposite walls of the soaking case, so the rolling columns are received in the accommodating space, wherein the surface of each of the rolling columns is provided with a plurality of elongated concave sections separated by a same interval; when chemical solution is filled in the accommodating space, the liquid level of chemical solution is not higher than the top ends of the rolling columns; when the rolling columns are rotated, an electronic component placed on top of the rolling columns is conveyed, and when the plural elongated concave sections of each of the rolling columns leave the surface of the chemical solution, the concave sections can suck and carry the chemical solution; so when each of the concave sections is rotated to the bottom surface of the electronic component, the chemical solution can be delivered to the bottom surface of the electronic component through liquid adhesion forces, and a single surface etching is therefore processed.

Another solution provided by the present invention is to provide a soaking device with single surface etching capability, installed in an etching tank of wet bench process, the device includes a soaking case, which is a case member with an open top end and has an accommodating space; and a convey mechanism composed by a plurality of rolling columns being in parallel and pivotally provided on two opposite walls of the soaking case, so the rolling columns are received in the accommodating space, wherein the surface of each of the rolling columns is provided with a plurality of concave through holes arranged in a matrix means, the matrix arrangement of the concave through holes can be regular or irregular; when chemical solution is filled in the accommodating space, the liquid level of chemical solution is not higher than the top end of the rolling columns; when the rolling columns are rotated, an electronic component placed on top of the rolling columns is conveyed, and when the plural concave through holes of each of the rolling columns leave the surface of the chemical solution, the concave through holes can suck and carry the chemical solution through liquid adhesion forces; so when each of the concave through holes is rotated to the bottom surface of the electronic component, the chemical solution can be delivered to the bottom surface of the electronic component through liquid adhesion forces of the concave through holes, and a single surface etching is therefore processed.

### BRIEF DESCRIPTION OF THE DRAWINGS

FIG. 1 is a cross sectional view of a conventional soaking device with double surface etching function;
FIG. 2 is a 3D view of the soaking device with single surface etching capability provided by the present invention;
FIG. 3 is a cross sectional view of FIG. 2 intercepted along an A-A line;
FIG. 4 is a partially-enlarged cross sectional view of FIG. 3;
FIG. 5 is a 3D view of the soaking device with single surface etching capability of another embodiment of the present invention;
FIG. 6 is a cross sectional view of FIG. 5 intercepted along a B-B line;
FIG. 7 is a partially-enlarged cross sectional view of FIG. 6.

### DETAILED DESCRIPTION OF THE PREFERRED EMBODIMENT

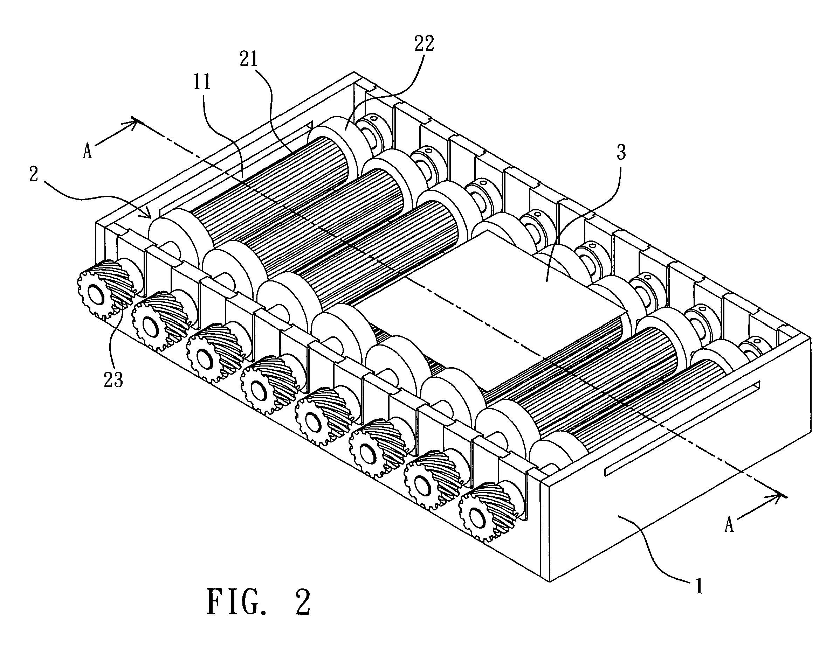

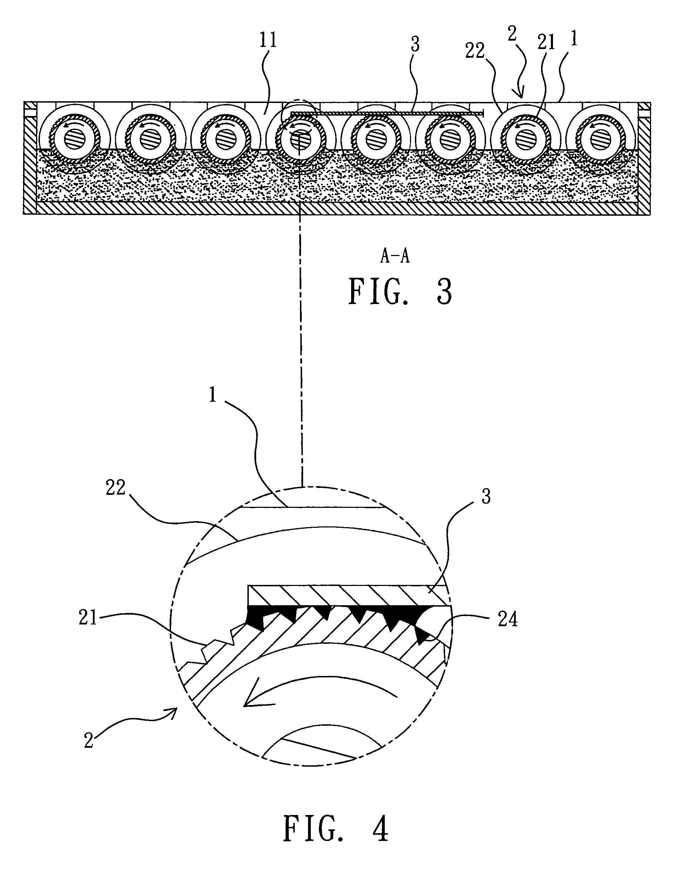

As shown in FIG. 2 and FIG. 3, the soaking device with single surface etching capability provided by the present invention is composed by a soaking case 1 and a convey mechanism 2; an electronic component such as a wafer can be processed with a single surface etching reaction through controlling liquid level of chemical solution contained in the soaking case 1.

The soaking case 1 is a case member with an open top end, and is provided in an etching wet bench; a solution filling hole (not shown) is provided at the bottom surface of the soaking case 1, so chemical solution in the etching wet bench is delivered to an accommodating space 11 of the soaking case 1 through pumping by a pump for processing an etching process on an electronic component, e.g. a wafer.

The convey mechanism 2 is composed by a plurality of rolling columns 21, the rolling columns 21 are in parallel and pivotally connected to the front and the rear walls of the soaking case 1 and are separated by intervals, so the rolling columns 21 are accommodated in the accommodating space 11. When the rolling columns 21 are rotated, an electronic component 3 placed on top of the rolling columns 21 is conveyed. For defining a moving path of the electronic component 3 to avoid an oblique movement, two ends of each of the rolling columns 21 are protrudingly and radially provided with a column ring 22 in accordance with the width of the electronic component 3. Moreover, each of the rolling columns 21 is axially and pivotally installed with a passive gear at an exterior end of one wall of the soaking case 1 e.g. the front wall, the passive gears 23 are engaged with a conventional transmission mechanism so the rolling columns 21 are able to be synchronously rotated.

The feature of the rolling columns 21 is that a plurality of elongated concave sections 24 are provided, by a same interval, on the surface of each of the rolling columns 21, as shown in FIG. 4, the concave section 24 is, e.g. but not limited to, in a V shape, the concave section 24 can also be in a U shape, rectangular or wedge shape. The purpose for installing the concave sections 24 is that the concave sections 24 serve to suck and carry chemical solution for processing a single surface etching function on the electronic component 3.

Referring to FIG. 2 to FIG. 4, when the present invention is carried out, chemical solution is firstly filled in the soaking case 1, the liquid level thereof is not higher than the top ends of the rolling columns 21, as shown in FIG. 3, the liquid level of the chemical solution in the soaking case 1 is around the height of the centers of the rolling columns 21. The electronic component 3 is then placed on the rolling columns 21 and the conveying mechanism is actuated, so each of the rolling columns 21 is rotated in a direction marked with an arrow (counterclockwise direction) as shown in FIG. 3, the electronic component 3 is conveyed from one end of the soaking case 1 to the other end thereof. Referring to FIG. 4, in the conveying process of the electronic component 3, when the plural elongated concave sections 24 provided on each of the rolling columns 21 leave the surface of the chemical solution, a certain amount of the chemical solution has already been sucked and carried in the concave sections 24; so when each of the concave sections 24 is rotated to the bottom surface of the electronic component 3, the chemical solution can be delivered to the bottom surface of the electronic component 3 through adhesion forces of the chemical solution, so a single surface etching process is performed on the bottom surface of the electronic component 3, therefore the object of the present invention is achieved.

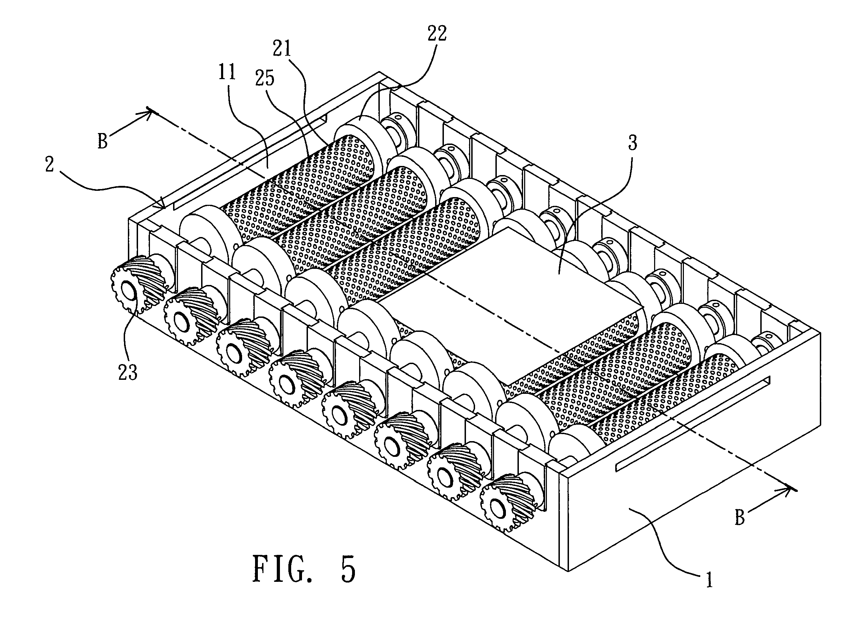

As shown in FIG. 5, which is a 3D view of the soaking device with single surface etching capability of another embodiment of the present invention, the difference between this embodiment and the previous embodiment is that the surface of each of the rolling columns 21 is provided with a plurality of concave through holes 25 arranged in a matrix means, the matrix arrangement of the concave through holes 25 can be regular or irregular. The diameters of the concave through holes 25 are not larger than 5mm, so the chemical solution is retained in the concave through holes 25 through a adhesion force, thus the chemical solution is sucked and carried by the concave through holes 25.

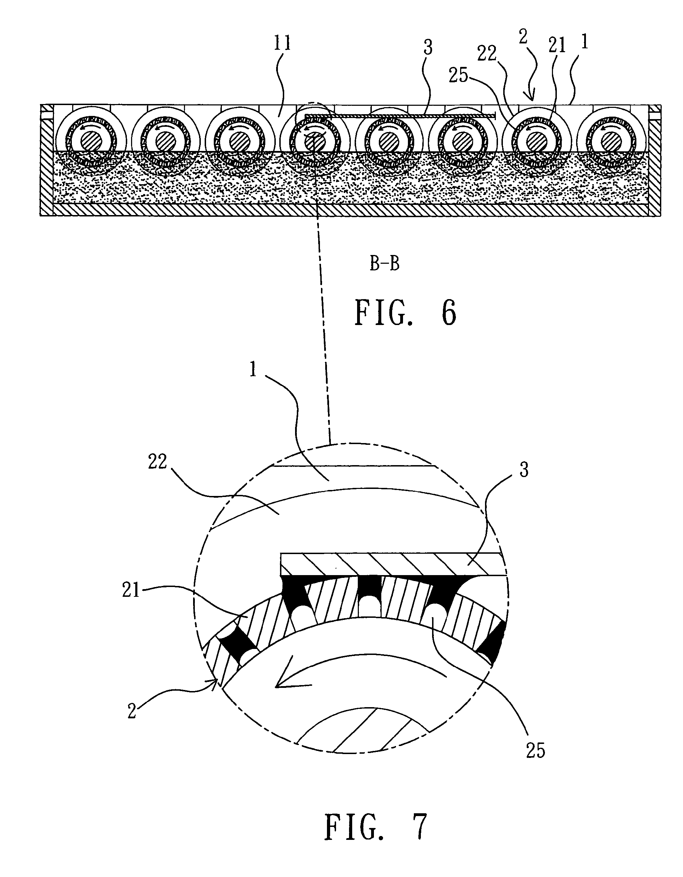

As shown in FIG. 6 and FIG. 7, which are a cross sectional view and a partially-enlarged cross sectional view of the rolling columns installed in the soaking device as shown in FIG. 5. The electronic component 3 is placed on top of the rolling columns 21 and the transmission mechanism is actuated, so each of the rolling columns 21 is rotated in a direction marked with an arrow (counterclockwise direction) as shown in FIG. 6, the electronic component 3 is conveyed from one end of the soaking case 1 to the other end thereof. Referring to FIG. 6, in the convey process of the electronic component 3, when the plural concave through holes 25 arranged in a matrix means provided on each of the rolling columns 21 leave the surface of the chemical solution, a certain amount of the chemical solution is sucked and carried in the concave through holes 25 through a adhesion force; so when each of the concave through holes 25 is rotated to the bottom surface of the electronic component 3, the chemical solution received in the concave through holes 25 can be delivered to the bottom surface of the electronic component 3, so a single surface etching process is performed on the bottom surface of the electronic component 3. Moreover, the concave through holes 25 described in this embodiment have a liquid exchange function so the etching reaction is facilitated.

The present invention improves the surface of a rolling column of a convey device, so the rolling column is able to suck and carry chemical solution with the same means like a waterwheel, so a bottom surface of an electronic component e.g. a wafer is processed with single surface etching function, and the top surface of the electronic component is not involved in etching, so a complicated process for preparing a protection layer or film to cover a non-etching surface (illustrated as the top surface of the wafer in this embodiment) is not needed. Moreover, the single surface etching function provided by the present invention allows an electronic component have a less material loss and the chemical solution is only served to etch one single surface of the electronic component, so the service life of the chemical solution is prolonged. Gas generated during the etching reaction is ventilated through the gaps between the rolling columns and a ventilation device is used to collect and discharge the generated gas so an operator is less likely to be harmed by the gas.

It is to be understood, however, that even though numerous characteristics and advantages of the present embodiments have been set forth in the foregoing description, together with details of the structures and functions of the embodiments, the disclosure is illustrative only, and changes may be made in detail, especially in matters of shape, size, and arrangement of parts within the principles of the invention to the full extent indicated by the broad general meaning of the terms in which the appended claims are expressed.

## Claims

1. A soaking device with single surface etching capability, installed in an etching tank of wet bench process, includes:
a soaking case, which is a case member with an open top end and has an accommodating space; and
a convey mechanism, a plurality of rolling columns is in parallel and pivotally provided on two opposite walls of the soaking case, so the rolling columns are received in the accommodating space, wherein the surface of each of the rolling columns is provided with a plurality of concave through holes arranged in a matrix means; when chemical solution is filled in the accommodating space, the liquid level of chemical solution is not higher than the top ends of the rolling columns; when the rolling columns are rotated, an electronic component placed on top of the rolling columns is conveyed, and when the plural concave through holes of each of the rolling columns leave the surface of the chemical solution, the concave through holes can suck and carry the chemical solution through liquid adhesion forces; so when each of the concave through holes is rotated to the bottom surface of the electronic component, the chemical solution can be delivered to the bottom surface of the electronic component through liquid adhesion forces of the concave through holes, a single surface etching is therefore processed.

2. The soaking device with single surface etching capability as claimed in claim 1, wherein the matrix arrangement of the concave through holes is regular or irregular.

3. The soaking device with single surface etching capability as claimed in claim 1, wherein the electronic component is a wafer.

4. The soaking device with single surface etching capability as claimed in claim 3, wherein the wafer is a solar cell wafer.

5. The soaking device with single surface etching capability as claimed in claim 1, wherein the diameter of the concave hole is not larger than 5mm.

6. The soaking device with single surface etching capability as claimed in claim 1, wherein two ends of the rolling column are protrudingly and radially provided with a column ring in accordance with the width of the electronic component.

7. The soaking device with single surface etching capability as claimed in claim 1, wherein the rolling column is pivotally provided with a passive gear at an exterior side of one wall of the soaking case.

8. A wafer soaking device with single surface etching capability, installed in an etching tank of wet bench process, includes:
a soaking case, which is a case member with an open top end and has an accommodating space; and
a convey mechanism, composed by a plurality of rolling columns being in parallel and pivotally provided on two opposite walls of the soaking case, so the rolling columns are received in the accommodating space, wherein the surface of each of the rolling columns is provided with a plurality of elongated concave sections separated with a same interval;
when chemical solution is filled in the accommodating space, the liquid level of chemical solution is not higher than the top ends of the rolling columns; when the rolling columns are rotated, a wafer placed on top of the rolling columns is conveyed, and when the plural elongated concave sections of each of the rolling columns leave the surface of the chemical solution, the concave sections suck and carry the chemical solution; so when each of the concave sections is rotated to the bottom surface of the wafer, the chemical solution is delivered to the bottom surface of the wafer through liquid adhesion forces, a single surface etching is therefore processed.

9. The wafer soaking device with single surface etching capability as claimed in claim 8, wherein the wafer is a solar cell wafer.

10. The wafer soaking device with single surface etching capability as claimed in claim 8, wherein the shape of the elongated concave section is in a V shape, U shape, rectangular or wedge shape.

11. The wafer soaking device with single surface etching as claimed in claim 8, wherein two ends of the rolling column are protrudingly and radially provided with a column ring in accordance with the width of the wafer.

12. The wafer soaking device with single surface etching as claimed in claim 8, wherein the rolling column is pivotally provided with a passive gear at an exterior side of one wall of the soaking case.
